(19) Europäisches Patentamt

European Patent Office

Office européen des brevets

(11) **EP 1 280 169 B1**

(12) **FASCICULE DE BREVET EUROPEEN**

(45) Date de publication et mention de la délivrance du brevet:
**31.03.2004 Bulletin 2004/14**

(51) Int Cl.7: **H01G 4/02**

(21) Numéro de dépôt: **02291793.4**

(22) Date de dépôt: **16.07.2002**

(54) **Condensateur de mesure à haute stabilité thermique pour lignes électriques blindées à isolation gazeuse**

Messkondensator mit hoher thermischer Stabilität für druckgasisolierte Hochspannungsschaltanlage

Measuring capacitor with high thermal stability for gas insulated high-voltage

(84) Etats contractants désignés:
**AT BE BG CH CY CZ DE DK EE ES FI FR GB GR IE IT LI LU MC NL PT SE SK TR**

(30) Priorité: **25.07.2001 FR 0109886**

(43) Date de publication de la demande:
**29.01.2003 Bulletin 2003/05**

(73) Titulaire: **Alstom**
**75116 Paris (FR)**

(72) Inventeurs:
• **Gutalj, Vladimir**
**5036 Oberentfelden (CH)**

• **Luscher, Robert**
**5703 Seon (CH)**
• **Regnier, Bernard**
**73100 Aix les Bains (FR)**
• **Dupraz, Jean-Pierre**
**01360 Bressolles (FR)**

(74) Mandataire: **Poulin, Gérard et al**
**Société BREVATOME**
**3, rue du Docteur Lancereaux**
**75008 Paris (FR)**

(56) Documents cités:
EP-A- 0 780 692        DE-A- 2 409 595
DE-A- 2 641 574        DE-A- 4 229 680
US-A- 3 646 412        US-A- 5 444 599

EP 1 280 169 B1

## Description

L'invention concerne un condensateur à haute stabilité thermique pour effectuer des mesures sur une ligne haute tension à isolation gazeuse, comportant une électrode haute tension s'étendant selon une direction longitudinale, un circuit imprimé cylindrique entourant coaxialement ladite électrode haute tension et comportant une piste électriquement conductrice formant une électrode basse tension, et un châssis définissant une surface interne cylindrique entourant coaxialement ledit circuit imprimé cylindrique, ledit circuit imprimé étant maintenu par ledit châssis.

Un tel condensateur est destiné tout particulièrement à des appareillages électriques de type blindés, c'est-à-dire avec une isolation gazeuse comme par exemple du SF6. Il est utilisé pour effectuer des mesures de la tension d'un élément à haute tension tel qu'un câble d'une ligne haute tension de type blindée. L'élément à haute tension est relié électriquement à l'électrode haute tension du condensateur tandis que le châssis du condensateur est relié électriquement à la masse. Un tel ensemble est par exemple installé dans un poste de distribution électrique situé en sortie d'une centrale de production d'électricité.

L'électrode haute tension du condensateur qui est généralement constituée d'une barre métallique à section ronde, est entourée par l'électrode basse tension qui est fixée au châssis tout en étant électriquement isolée de celui-ci. Le châssis du condensateur est connecté à la masse de manière à former un pont diviseur capacitif entre l'électrode haute tension et la masse. Plus particulièrement, le pont diviseur comprend un premier condensateur constitué de l'électrode haute tension et de l'électrode basse tension, qui est monté en série avec un second condensateur constitué de l'électrode basse tension et du châssis. La tension de l'électrode basse tension est donc une image de la haute tension, et cette électrode basse tension est reliée à un dispositif de mesure.

Avec un tel agencement, les valeurs de mesure de tension sont notamment fonction de la capacité C du premier condensateur qui est donnée par la relation bien connue :

$$C = K \cdot \frac{S}{D \cdot \ln\left(\dfrac{D}{d}\right)} \qquad (1)$$

dans laquelle $K$ est une constante, $D$ et $S$ le diamètre et la surface de l'électrode basse tension, et d le diamètre de l'électrode haute tension. Ce type de condensateur est généralement placé à l'extérieur et subit des variations de température s'étendant entre - 40°C et + 80°C. Ces fluctuations provoquent des dilatations ou des contractions de ses matériaux constitutifs qui font varier sa capacité dans des proportions importantes puisque les matériaux ont leurs dimensions qui évoluent selon la relation bien connue :

$$L(T) = L_0(1 + a \cdot (T - T_0)) \qquad (2)$$

dans laquelle $L(T)$ désigne une longueur à la température $T$, $L_0$ cette longueur à une température de référence $T_0$, et a le coefficient de dilatation linéaire du matériau correspondant. Un accroissement de température produit une augmentation de la surface S et du diamètre D de l'électrode basse tension qui induit une variation de la capacité du condensateur, en vertu des relations (1) et (2). Les fluctuations de la température induisent ainsi des variations de la capacité qui perturbent la précision de mesure.

Dans la conception d'un tel condensateur, on cherche donc à minimiser l'influence de la température sur la capacité pour obtenir une stabilité thermique donnant une précision de mesure satisfaisante. Cette optimisation consiste généralement à concevoir une architecture mécanique particulière qui est associée à un choix de matériaux constitutifs ayant des coefficients de dilatation adaptés.

Il est connu du brevet français FR-2705492 un condensateur tel qu'indiqué plus haut dans lequel l'électrode basse tension est constituée de plusieurs plaques courbes longeant la périphérie interne du châssis, ces plaques sont fixées au châssis tout en étant libres de se dilater ou de se contracter. Dans ce condensateur connu, la variation de diamètre de l'électrode basse tension est donc conditionnée par le coefficient de dilatation du matériau constituant le châssis puisque les plaques sont fixées à celui-ci. Les variations de la surface de l'électrode basse tension sont conditionnées par le coefficient de dilatation du ou des matériaux formant les plaques. En combinant les relations (1) et (2) on montre que la stabilité thermique est satisfaisante si le rapport du coefficient de dilatation thermique du matériau constituant le châssis sur celui du matériau constituant l'électrode basse tension est compris entre un et demi et deux et demi. Ce condensateur connu a une stabilité thermique satisfaisante, mais une fabrication onéreuse du fait de la nécessité de fixer une pluralité de plaques à la périphérie interne du châssis.

Il est encore connu du brevet allemand DE-2409595, un condensateur cylindrique renfermant un circuit imprimé cylindrique ayant sa face interne revêtue d'une couche métallique pour former l'électrode basse tension. Cette construction avec un circuit imprimé cylindrique pour l'électrode basse tension est très simple et permet d'en réduire le coût de fabrication. Cependant, ce circuit imprimé cylindrique qui est libre de se dilater et de se contracter à l'intérieur du châssis sous l'effet des variations de température, rend ce condensateur trop sensible aux variations de température.

Le but de l'invention est de remédier à ces inconvénients en proposant un condensateur de construction simple présentant une stabilité thermique élevée.

A cet effet, l'invention a pour objet un condensateur à haute stabilité thermique pour effectuer des mesures sur une ligne haute tension à isolation gazeuse, comportant une électrode haute tension s'étendant selon une direction longitudinale, un circuit imprimé cylindrique entourant coaxialement ladite électrode haute tension et comportant une piste électriquement conductrice formant une électrode basse tension, et un châssis définissant une surface interne cylindrique entourant coaxialement ledit circuit imprimé cylindrique, ledit circuit imprimé étant maintenu par ledit châssis, caractérisé en ce que ledit circuit imprimé est fendu le long d'une génératrice du cylindre qu'il forme, et en ce que ledit châssis comprend des moyens de guidage pour maintenir ledit circuit imprimé à proximité de la surface interne tout en le laissant libre de se dilater le long de ladite surface interne.

Une telle construction fait qu'avec un choix adapté des coefficients de dilatation thermique pour les matériaux constituant l'électrode basse tension et le châssis, on obtient un condensateur à haute stabilité thermique et de construction très simple.

Selon un mode de réalisation préféré du condensateur selon l'invention, plusieurs points de fixation du circuit imprimé sont prévus sur la surface interne du châssis, lesdits points de fixation étant répartis le long d'une autre génératrice du cylindre que forme le circuit imprimé, cette autre génératrice étant disposée de façon symétrique à la génératrice selon laquelle le cylindre est fendu, par rapport à la direction longitudinale. Avec cette construction, le circuit imprimé ne risque pas de s'arc-bouter dans le châssis.

Selon un autre mode de réalisation particulier du condensateur selon l'invention, les moyens de guidage sont deux anneaux fixés le long de la surface interne du châssis, lesdits anneaux ayant chacun une section en L pour former avec ladite surface interne deux gorges circulaires se faisant face et ayant chacune une section en U, le cylindre que forme le circuit imprimé ayant ses bases emboîtées dans chaque gorge. Avec cette construction, les moyens de guidage du circuit imprimé sur le châssis sont principalement constitués de deux pièces, pour simplifier les opérations de montage du condensateur et réduire son coût.

Selon encore un autre mode de réalisation particulier du condensateur selon l'invention, chaque anneau comporte une rainure circulaire s'étendant sur toute sa périphérie en faisant face au circuit imprimé, et un ressort hélicoïdal est logé dans chaque rainure, le ressort ayant ses spires s'étendant sensiblement dans des plans radiaux, chaque spire appuyant sur le circuit imprimé pour le maintenir à proximité de la surface interne du châssis. Avec cette construction, les gorges peuvent avoir une largeur significativement supérieure à l'épais

seur du circuit imprimé pour faciliter l'emboîtement du circuit imprimé.

Selon encore un autre mode de réalisation particulier du condensateur selon l'invention, le circuit imprimé a des coefficients de dilatation thermique ax, ay respectivement selon la direction longitudinale et le long de sa périphérie qui sont liés au coefficient de dilatation thermique ac du châssis par la relation :

$$0,75 \leq \frac{a_x + a_y}{a_c} \leq 1,25$$

Avec cette construction, le condensateur a une dérive thermique inférieure à 0,085 % pour une plage de température variant entre - 40 et + 80 °C.

L'invention sera maintenant décrite plus en détail, et en référence aux dessins annexés qui en illustrent une forme de réalisation à titre d'exemple non limitatif.

La figure 1 est une vue en coupe du condensateur selon l'invention
La figure 2 est une vue en perspective du circuit imprimé cylindrique
La figure 3 est une vue en coupe d'un anneau de guidage du circuit imprimé sur le châssis.

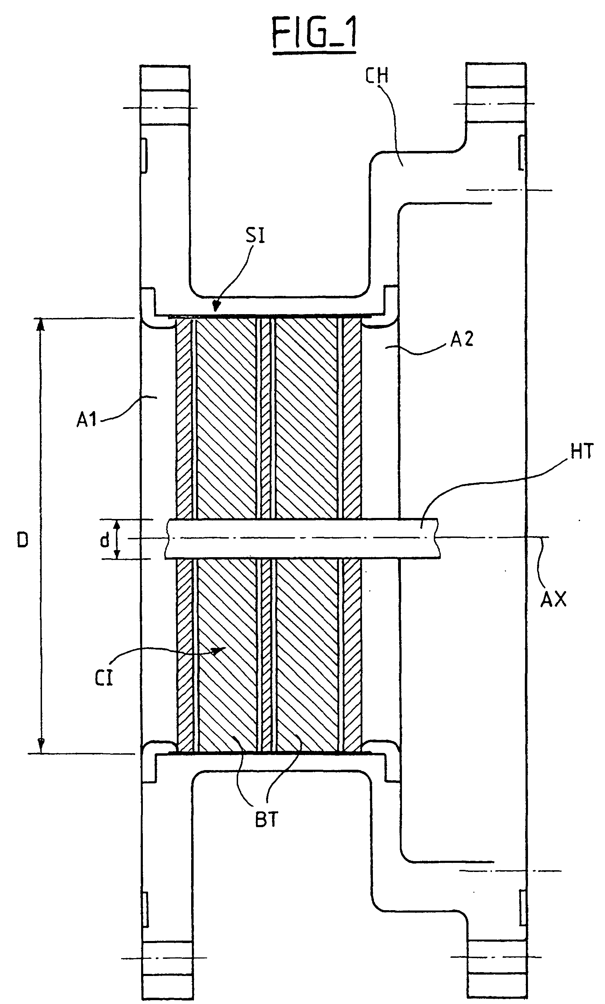

Le condensateur à haute stabilité thermique selon l'invention est un condensateur cylindrique. Il comprend une électrode haute tension HT qui s'étend selon une direction principale AX, comme représenté dans la figure 1 qui est une vue du condensateur selon un plan de coupe comprenant l'axe AX. L'électrode HT, qui est ici une barre métallique à section ronde de diamètre d, est entourée de façon coaxiale par une électrode basse tension BT sous la forme d'une piste électriquement conductrice d'un circuit imprimé CI cylindrique de diamètre D. Ce circuit imprimé est maintenu dans un châssis CH métallique destiné à être accouplé à un appareillage blindé rempli de SF6. Dans cet exemple, le circuit imprimé cylindrique CI comporte cinq pistes électriquement conductrices distinctes disposées sur sa face interne. Ces pistes forment des bandes circulaires représentées sur les dessins par des zones hachurées, ces bandes étant espacées les unes des autres le long de l'axe AX. Ces bandes ne sont pas nécessairement interconnectées au niveau du circuit imprimé. Plus particulièrement, les pistes centrales qui ne sont pas reliées à la masse du châssis CH peuvent jouer le rôle d'électrode basse tension BT indépendamment les unes des autres. Le châssis CH comporte une surface interne cylindrique SI s'étendant coaxialement à l'axe AX et qui entoure le circuit imprimé CI pour le maintenir en position par rapport à l'électrode haute tension HT. Comme dans d'autres condensateurs connus, le châssis est connecté à la masse de manière à former un pont diviseur capacitif entre l'électrode haute tension HT et la masse. La tension de l'électrode basse tension est ainsi une image de la tension de l'électrode haute tension, et cette électrode basse tension BT est reliée électriquement à un dispositif de mesure non représenté. Ce système de mesure pourra être relié à une ou à plusieurs bandes conductrices du circuit imprimé cylindrique CI pour effectuer une ou plusieurs mesures du potentiel électrique par rapport à la masse du châssis. Il est à noter que le circuit imprimé cylindrique CI comporte également une piste conductrice sur sa surface externe, cette piste conductrice étant reliée à la masse à travers le châssis.

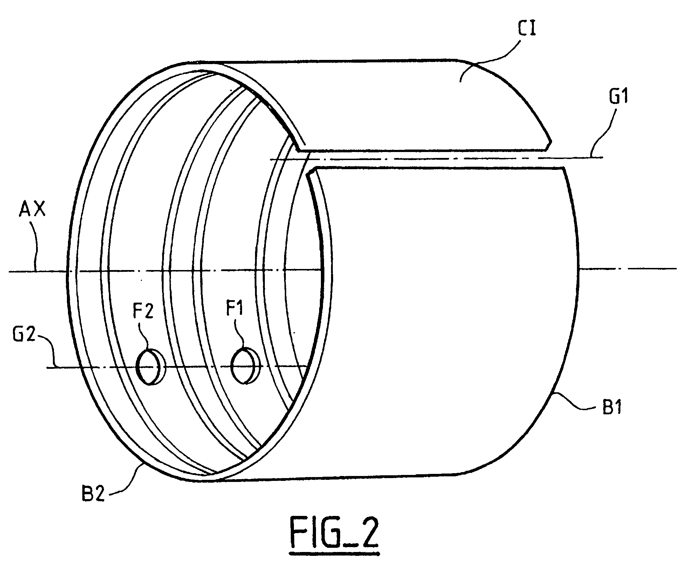

Selon l'invention, le circuit imprimé CI est fendu le long d'une génératrice G1 du cylindre qu'il forme, comme représenté dans la figure 2, et le châssis comprend des moyens de guidage pour maintenir le circuit imprimé CI en position dans le châssis. Ces moyens de guidage A1, A2 sont agencés pour maintenir le circuit imprimé CI à proximité de la surface interne SI du châssis CH c'est à dire à distance sensiblement constante, tout en le laissant libre de se dilater le long de cette surface interne SI. Le circuit imprimé CI pourra être maintenu par l'intermédiaire des moyens de guidage A1,A2 à faible distance de la surface interne SI du châssis, ou encore plaqué contre celle-ci. La fente du circuit imprimé CI a donc une largeur qui fluctue avec les variations de température.

Le circuit imprimé CI sera de préférence fixé au châssis en un ou plusieurs points de fixation de telle manière à l'empêcher de tourner indéfiniment à l'intérieur de la surface interne cylindrique SI du châssis. Avec cet agencement, le circuit imprimé est libre de s'allonger ou de rétrécir le long de la surface interne SI sous l'effet des fluctuations de la température, tout en ayant son diamètre D imposé par la surface interne SI du châssis. Comme dans le condensateur du document FR-2705492 la variation de la surface S de l'électrode BT est conditionnée par le coefficient de dilatation de l'électrode BT, alors que la variation de son diamètre D est conditionnée par le coefficient de dilatation du châssis CH. Il en découle qu'un choix approprié des coefficients de dilatation de l'électrode BT et du châssis CH permet d'obtenir une stabilité thermique satisfaisante, comme expliqué dans le document précité.

Ainsi le condensateur selon l'invention présente une stabilité thermique satisfaisante tout en ayant une conception plus simple que celle du condensateur connu du document FR-2705492.

Selon l'invention, l'électrode BT est constituée d'un unique circuit imprimé, alors que dans le document FR-2705492, elle est constituée d'une pluralité de plaques courbes fixées séparément au châssis.

De préférence, le circuit imprimé CI sera fixé au châssis en plusieurs points de fixation F1 et F2 montrés sur la figure 2, ces points de fixation étant répartis le long d'une génératrice G2 du cylindre que forme le circuit CI, cette génératrice G2 étant disposée de façon symétrique à la génératrice G1 selon laquelle le cylindre est fendu, par rapport à la direction longitudinale AX. Plusieurs points de fixation F1 et F2 répartis sur une même génératrice telle que G2 garantissent que les déplacements du circuit imprimé CI le long de la surface interne SI du châssis se font de manière homogène, c'est à dire sans risque d'arc-boutement du circuit imprimé dans la surface interne du châssis. Les points de fixation F1 et F2 peuvent être simplement des trous dans le circuit CI destinés à recevoir des vis complémentaires venant se visser dans des taraudages correspondants de la surface interne SI du châssis. Du fait que les points de fixation F1,F2 sont disposés face à la fente du cylindre CI, il en résulte que les déplacements relatifs du circuit imprimé par rapport au châssis sont minimisés. D'autres systèmes de fixation peuvent également être utilisés sans sortir du cadre de l'invention.

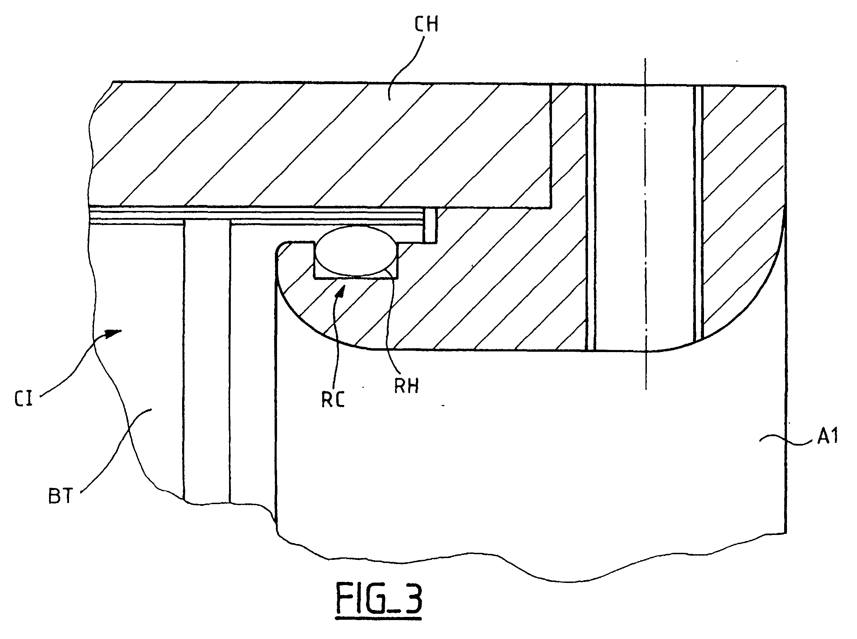

Les moyens de guidage du circuit CI sur la surface interne SI du châssis peuvent être réalisés de plusieurs manières. Par exemple avec des organes solidaires du circuit imprimé et coulissant dans des rainures correspondantes aménagées dans la surface interne SI du châssis. Dans un mode de réalisation préféré, ces moyens de guidage sont constitués par deux anneaux A1, A2 disposés coaxialement à la surface cylindrique SI et fixés à celle-ci. Ces anneaux ont chacun une section transversale formant un "L", comme visible dans la figure 3, et ils sont montés respectivement aux deux aux deux extrémités du cylindre que constitue la surface SI pour former avec elle deux gorges circulaires ayant une section transversale formant un "U". Ces gorges ont une hauteur légèrement supérieure à l'épaisseur du circuit imprimé CI pour qu'il puisse y être emboîté. Ainsi, le cylindre que forme le circuit imprimé CI a chacune de ses bases circulaires B1, B2 emboîtée dans l'une des gorges pour être maintenu à une distance constante de la surface cylindrique SI du châssis tout en pouvant se dilater le long de cette surface en coulissant dans les gorges. Avec un tel agencement, l'assemblage des éléments constitutifs du condensateur est très simple puisqu'il peut consister à fixer le circuit imprimé CI au châssis au niveau des points F1 et F2, puis à monter les deux anneaux A1 et A2 pour les fixer au châssis CH tout en emboîtant le circuit imprimé CI dans les gorges définies par les anneaux et la surface interne SI du châssis. Ces anneaux peuvent être par exemple fixés au châssis par vissage.

Selon encore un mode de réalisation particulier du condensateur selon l'invention, le circuit imprimé CI qui est guidé par lesdites gorges est encore plaqué par un ressort contre la surface SI du châssis. Pour ce faire, chaque anneau profilé comporte une rainure circulaire RC qui s'étend sur toute la périphérie extérieure de l'anneau et qui fait face au circuit imprimé CI, comme visible dans la figure 3. Cette rainure RC a ici une section transversale rectangulaire et reçoit un ressort hélicoïdal RH torique. Le ressort RH est donc logé dans la rainure RC en ayant ses spires qui s'inscrivent sensiblement dans des plans radiaux. Ce montage du ressort RH dans l'anneau est similaire au montage du ressort torique d'un joint à lèvre pour arbre tournant, encore appelé joint torique. Dans ce mode de réalisation, chaque spire du ressort RH est comprimée entre la rainure RC et le circuit cylindrique CI de telle sorte que chaque spire appuie sur le circuit imprimé pour le maintenir plaqué à la surface cylindrique SI du châssis. Ainsi, les gorges peuvent avoir une hauteur significativement supérieure à l'épaisseur du circuit imprimé pour faciliter l'emboîtement de ses bases dans les gorges au cours de l'opération de montage. Avec cet agencement, le circuit est plaqué contre la surface cylindrique SI du châssis pour améliorer encore la stabilité thermique du condensateur et pour diminuer encore plus les risques d'arc-boutement du circuit imprimé par rapport au châssis. Cet agencement contribue à simplifier les opérations d'assemblage des pièces constitutives du condensateur selon l'invention car les gorges de guidage peuvent être agrandies.

Selon un autre mode de réalisation préféré du condensateur, le coefficient de dilatation $a_c$ du châssis CH et les coefficients de dilatation $a_x$ et $a_y$ du circuit imprimé CI respectent la relation :

$$0,75 \leq \frac{a_x + a_y}{a_c} \leq 1,25$$

dans laquelle $a_x$ et $a_y$ désignent respectivement les coefficients de dilatation linéaire du circuit imprimé selon la direction AX et le long de la surface SI. En effet, en combinant les relations (1) et (2), on montre que la sensibilité de la capacité C du condensateur aux variations de température est principalement conditionnée par ces trois coefficients de dilatation, selon la relation :

$$C(T) \approx K'.\frac{1 + (a_x + a_y)(T - T_0)}{1 + a_c.(T - T_0)}$$

dans laquelle $C(T)$ est la capacité du condensateur à la température $T$, et $K'$ une constante. Cette relation fait apparaître qu'en prenant $a_x + a_y = a_c$, le condensateur est insensible aux variations de température. Plus généralement, on montre que si le rapport des coefficients de dilatation est compris entre 0,75 et 1,25, la variation de la capacité pour une température qui fluctue entre - 40 et +80°C est inférieure à 0,085 % de la capacité nominale.

Avantageusement, le condensateur selon l'invention aura son circuit imprimé CI fabriqué sur une base de résine époxy et son châssis CH en aluminium. Les coefficients de dilatation linéaires du circuit imprimé CI valent alors environ $a_x + a_y = 21.10^{-6}$ °C$^{-1}$.m$^{-1}$, et pour le châssis CH en aluminium, on a : $a_c = 23,3.10^{-6}$ °C$^{-1}$. m$^{-1}$, ce qui produit une variation de capacité inférieure à 0,03 % de la capacité nominale pour une température fluctuant entre - 40 et +80°C.

## Revendications

1. Condensateur à haute stabilité thermique pour effectuer des mesures sur une ligne haute tension à isolation gazeuse, comportant une électrode haute tension (HT) s'étendant selon une direction longitudinale (AX), un circuit imprimé (CI) cylindrique entourant coaxialement ladite électrode haute tension et comportant une piste électriquement conductrice formant une électrode basse tension (BT), et un châssis (CH) définissant une surface interne cylindrique (SI) entourant coaxialement ledit circuit imprimé cylindrique (CI), ledit circuit imprimé étant maintenu par ledit châssis (CH), **caractérisé en ce que** ledit circuit imprimé est fendu le long d'une génératrice (G1) du cylindre qu'il forme, et **en ce que** ledit châssis (CH) comprend des moyens de guidage (A1, A2) pour maintenir ledit circuit imprimé (CI) à proximité de la surface interne (SI) tout en le laissant libre de se dilater le long de ladite surface interne.

2. Condensateur selon la revendication 1, comportant plusieurs points de fixation (F1, F2) du circuit imprimé (CI) sur la surface interne (SI), lesdits points de fixation étant répartis le long d'une autre génératrice (G2) du cylindre que forme le circuit imprimé, ladite autre génératrice (G2) étant disposée de façon symétrique à la génératrice (G1) selon laquelle le cylindre est fendu, par rapport à la direction longitudinale (AX).

3. Condensateur selon la revendication 1 ou 2, dans lequel les moyens de guidage sont deux anneaux profilés (A1, A2) fixés le long de la surface interne (SI) du châssis (CH), lesdits anneaux ayant chacun une section en L pour former avec ladite surface interne deux gorges circulaires se faisant face et ayant chacune une section en U, le cylindre que forme le circuit imprimé ayant ses bases emboîtées dans les deux gorges.

4. Condensateur selon la revendication 3, dans lequel chaque anneau (A1, A2) comporte une rainure (RC) circulaire s'étendant sur toute sa périphérie en faisant face au circuit imprimé (CI), et dans lequel un ressort hélicoïdal (RH) est logé dans chaque rainure, ledit ressort ayant ses spires s'étendant sensiblement dans des plans radiaux, chaque spire appuyant sur le circuit imprimé (CI) pour le maintenir plaqué à la surface interne (SI) du châssis.

5. Condensateur selon l'une des revendications 1 à 4, dans lequel ledit circuit imprimé a des coefficients

de dilatation thermique $a_x$, $a_y$ respectivement selon la direction longitudinale et le long de sa périphérie qui sont liés au coefficient de dilatation thermique $a_c$ du châssis par la relation :

$$0,75 \leq \frac{a_x + a_y}{a_c} \leq 1,25$$

**Patentansprüche**

1. Kondensator mit hoher thermischer Stabilität zur Durchführung von Messungen an einer Hochspannungsleitung mit Gasisolation, umfassend eine in einer Längsrichtung (AX) verlaufende Hochspannungselektrode (HT), eine zylindrische gedruckte Schaltung (CI), die die Hochspannungselektrode koaxial umgibt und eine elektrisch leitende Bahn umfasst, die eine Niederspannungselektrode (BT) bildet, sowie einen Rahmen (CH), der eine zylindrische Innenoberfläche (SI) definiert, welche die zylindrische gedruckte Schaltung (CI) koaxial umgibt, wobei die gedruckte Schaltung durch den Rahmen (CH) gehalten wird, **dadurch gekennzeichnet, dass** die gedruckte Schaltung entlang einer Erzeugenden (G1) des Zylinders, den sie bildet, geschlitzt ist, und dass der Rahmen (CH) Führungsmittel (A1, A2) zum Halten der gedruckten Schaltung (CI) nahe der Innenoberfläche (SI) umfasst, die es ihr jedoch ermöglichen, sich entlang der Innenoberfläche auszudehnen.

2. Kondensator nach Anspruch 1, umfassend mehrere Punkte zur Befestigung (F1, F2) der gedruckten Schaltung (CI) an der Innenoberfläche (SI), welche Befestigungspunkte entlang einer anderen Erzeugenden (G2) des Zylinders verteilt sind, den die gedruckte Schaltung bildet, wobei die andere Erzeugende (G2) bezüglich der Längsrichtung (AX) symmetrisch zur Erzeugenden (G1) angeordnet ist, entlang welcher der Zylinder geschlitzt ist.

3. Kondensator nach Anspruch 1 oder 2, bei dem die Führungsmittel zwei entlang der Innenoberfläche (SI) des Rahmens (CH) befestigte Profilringe (A1, A2) sind, welche Ringe jeweils einen L-Querschnitt aufweisen, um mit der Innenoberfläche zwei Kreisauskehlungen zu bilden, die sich gegenüber liegen und jeweils einen U-Querschnitt haben, wobei die Basen des durch die gedruckte Schaltung gebildeten Zylinders in die zwei Auskehlungen eingesetzt sind.

4. Kondensator nach Anspruch 3, bei dem jeder Ring (A1, A2) eine Kreisrille (RC) umfasst, die sich über seinen gesamten Umfang erstreckt, wobei sie der gedruckten Schaltung (CI) gegenüberliegt, und bei dem in jeder Rille eine Schraubenfeder (RH) aufgenommen ist, wobei die Wicklungen der Feder sich im Wesentlichen in radialen Ebenen erstrecken, wobei jede Wicklung auf die gedruckte Schaltung (CI) drückt, um sie an die Innenoberfläche (SI) des Rahmens gedrückt zu halten.

5. Kondensator nach einem der Ansprüche 1 bis 4, bei dem die gedruckte Schaltung thermische Ausdehnungskoeffizienten $a_x$, $a_y$ in der Längsrichtung bzw. entlang ihres Umfangs aufweist, die mit dem thermischen Ausdehnungskoeffizienten $a_c$ des Rahmens verknüpft sind durch die Relation:

$$0,75 \leq \frac{a_x + a_y}{a_c} \leq 1,25$$

**Claims**

1. A capacitor of high thermal stability for carrying out measurements on a gas-insulated high-voltage line, including a high-voltage electrode (HT) extending in a longitudinal direction (AX), a cylindrical printed circuit (CI) coaxially surrounding said high-voltage electrode and including an electrically conductive track forming a low-voltage electrode (BT), and a frame (CH) having a cylindrical inside surface (SI) coaxially surrounding said cylindrical printed circuit (CI), which is held by said frame (CH), **characterized in that** said printed circuit is slit along a generatrix (G1) of the cylinder that it forms and **in that** said frame (CH) includes guide means (A1, A2) for holding said printed circuit (CI) near the inside surface (SI) whilst allowing it to expand along said inside surface.

2. A capacitor according to claim 1, including a plurality of fixing points (F1, F2) for fixing the printed circuit (CI) to the inside surface (SI), said fixing points being distributed along another generatrix (G2) of the cylinder formed by the printed circuit symmetrical to the generatrix (G1) along which the cylinder is slit with respect to the longitudinal direction (AX).

3. A capacitor according to claim 1 or claim 2, wherein the guide means are two profiled rings (A1, A2) fixed along the inside surface (SI) of the frame (CH), said rings each having an L-shaped section to form with said inside surface two circular grooves facing each other and each having a U-shaped section, the cylinder that the printed circuit forms having its bases nested in the two grooves.

4. A capacitor according to claim 3, wherein each ring (A1, A2) includes a circular groove (RC) extending all around its periphery and facing the printed circuit (CI), and wherein a respective helicoidal spring (RH) is housed in each groove, said springs having their turns in substantially radial planes, each turn bearing on the printed circuit (CI) to hold it pressed onto the inside surface (SI) of the frame.

5. A capacitor according to any of claims 1 to 4, wherein said printed circuit has coefficients of thermal expansion $a_x$, $a_y$ respectively in the longitudinal direction and along its periphery that are related to the coefficient of thermal expansion $a_c$ of the frame by the condition:

$$0.75 \leq \frac{a_x + a_y}{a_c} \leq 1.25$$

# FIG_1

EP 1 280 169 B1

CI

G1

AX

G2

F2

F1

B1

B2

## FIG_2

FIG_3